# EUROPEAN PATENT APPLICATION

(11) **EP 2 922 100 A1**
(43) Date of publication of application: **23.09.2015**
(21) Application number: 14161115.2
(22) Date of filing: 21.03.2014
(51) Int. Cl.: H01L 31/0232, H01L 31/0236, H01L 31/052, H01L 31/0216

(54) **Absorption enhancement structure**

(71) Applicant: Hemain, Christopher, 10405 Berlin (DE)
(72) Inventor: Hémain, Christopher, 10405 Berlin (DE); Estroff, Andrew, Hillsboro, OR 97123 (US)
(74) Representative: Müller Schupfner & Partner Patent- und Rechtsanwaltspartnerschaft mbB

(57) **Abstract**

This invention relates to a cell structure in particular for use in thin layer cells comprising a reflector and an absorbing layer wherein the reflector has an upper side and a lower side, wherein the upper side is heading towards the absorbing layer wherein at the upper side the reflector comprises a cavity consisting of dielectric material.

## Description

This invention relates to an absorption enhancement structure for use in thin film solar cells and to a cell structure utilizing such an absorption enhancement structure.

Devices for transforming radiation energy into electrical energy are well known from the prior art. Recent advances have focused on utilizing very thin layers of material to transform, for example, sunlight into electric current. One of the most significant drawbacks when using a very thin absorbing layer is that the amount of energy that can be absorbed in this active layer is still too low. The theoretical relationship describing this phenomenon was described in a mathematical model by Eli Yablonovitch, saying that the thinner the layer becomes the less light it is capable of absorbing. Furthermore, the so-called "price per watt" metric, expressing the theoretical production costs of a solar cell generating 1 W of electric energy, of current thin film solar cells is still very high which means that producing such solar cells is still too expensive in view of the performance those cells are capable of. Reducing solar cell material consumption is also useful for space-based deploy-ments, which have a limited Delta V budget and have severe weight restrictions. Recent research has therefore been directed to options for enhancing absorption in thin film solar cells. It has been found that placing silver nano-particles on top of the thin layer leads to light scattering and an improved absorption. Another solution is to cut relief-like structures into the absorbing layer of a thin film cell. However, the known solutions do not provide sufficient absorption rates, are comprised of expensive materials and are costly to produce, and therefore do not provide sufficient enhancement to represent marketable solutions.

It is therefore an object of the current invention to provide a structure, which improves absorption in thin solar cells, which in turn lowers material consumption and improves price per watt characteristics. It is a further object of the current invention to improve the efficiency of the solar cells in which it is used.
This objective is achieved by means of an absorption enhancement structure according to claim 1 and a cell structure according to claim 12. Additional advantages and features of preferred embodiments of the current invention are defined in the dependent claims.

According to the invention the structure comprises a reflector and an absorbing layer, wherein the reflector has an upper side and a lower side, wherein the upper side is heading or oriented towards the absorbing layer and wherein at the upper side the reflector incorporates a cavity filled with a dielectric material. The structure according to the invention is in other words an arrangement of several layers wherein one layer, the reflector, comprises a cavity filled with or consisting of dielectric material. The reflector material is preferably metal and the reflector preferably has a basically flat shape. For means of a better comprehension it is to be defined that the reflector has an upper side, which is heading or oriented towards the absorbing layer. At the upper side of the reflector there is arranged a cavity, which might for instance be created by adding additional layers or additional material to the upper side of the reflector or by deepening this cavity into the upper side or upper surface of the reflector. In this manner, the reflector material surrounds the cavity. In one direction, e.g. the direction heading or oriented towards the absorbing layer, the cavity material does not abut the reflector material but the material of the absorbing layer. According to the invention, the cavity consists of dielectric material such as silicon dioxide (glass), which is cheap and easy to produce. Advantageously, the use of a combination of metal and a dielectric allows for the generation of a secondary surface plasmon resonance, which can be tuned for certain wavelengths. Accordingly, the cavity may also be defined as metal/dielectric cavity, since the best results have been discovered when applying this material combination. Furthermore, the use of a dielectric material allows the cavity to support multiple resonant modes that can be tuned for optimal performance and thereby enhancing the absorption rate of the structure according to the invention.

In a preferred embodiment the absorbing layer has a planar top surface and a planar bottom surface wherein the bottom surface is preferably in close proximity to the upper side of the reflector. Several tests by the inventor have shown that it is advantageous for the electrical performance of the absorbing layer to keep the upper surface as well as the bottom surface of the absorbing layer basically flat, respectively planar. As an explanation for this effect it has been found that using a planar absorbing layer will decrease the losses due to recombination processes at the surface of the absorbing layer. If the surface of the absorbing medium were textured, the surface area of the absorbing medium would be increased. This greater surface area would lead to greater distances for charge carriers (electrons) to travel and the likelihood that these carriers would recombine with the material would be increased. This recombination process produces thermal energy instead of flow-charge-energy. It has been described as advantageous to increase the surface area of the absorbing medium, while having a textured absorber surface increase optical absorption the inventors of the current invention, and others have demonstrated that increased surface area in fact causes significant electrical losses due to recombination processes in the absorbing layer which lower the overall-efficiency of this absorbing layer. Since these losses substantially decrease the performance of a thin film cell the use of a planar absorbing layer provides for a cell with greater efficiency and electrical output making the structural configuration according to the invention preferable. Ideally, the absorbing layer is deposited onto the reflector via one of several deposition techniques, such as sputtering, evaporation, some form of chemical vapour deposition (CVD), molecular beam epitaxy (MBE), or atomic layer deposition (ALD), with the deposition method to be determined by the materials used and thickness required. Materials are chosen for their physical properties, lattice matching (if required), and their ability to adhere to one another.

In a further preferred embodiment the absorbing layer directly contacts the material of the reflector and/or the cavity. It has been discovered by the inventor that the effects achieved by the dielectric/metal cavity are maximally effective when the absorbing layer is located as close as possible to the cavity and/or the reflector material. On one hand, where the absorbing layer contacts the dielectric material or the reflector material, plasmonic effects generated at the interface between the metal and other materials will cause the metal to absorb some light. This absorption of light by the metal is referred to as "parasitic absorption" and counts as a loss in the absorption efficiency. On the other hand, it has been discovered that despite these parasitic losses, the performance gains considerably surpass any of the current solutions.
The preferred embodiment has the cavity in direct contact with the cavity, however in some cases the cavity may be separated from the absorbing medium by up to 500 nanometers.

It is preferred that the absorbing layer have a thickness of 5 nm to 10 microns, preferably 50 nm to 5 microns and in particular preferred of 200 nm to 5 microns. To find an optimal compromise between material costs and a sufficient capability of absorbing radiation energy the absorbing layer thickness is preferably between 200nm and 5 microns. Within this range it has been found that the advantage of thin film materials as well as a sufficient absorbing capability can be achieved. For a range of 5 nm to 5 microns it has been found that efficiency characteristics are considerably increased. Generally the strength of the absorption, and therefore efficiency enhancement benefits decrease when leaving this range, with the utility of the structure dropping off substantially when absorber thickness exceeds 10 microns.

Preferably, the absorbing layer consists of Crystalline Silicon (Si or C-Si), and/or Amorphous Silicon (a-Si) and/or Copper Indium Gallium Selenide Cu(In,Ga)Se2 (CIGSe) and/or Gallium Arsenide (GaAs) and/or Indium Gallium Selenide (In-GaAs) and/or Organic absorbers (e.g. MEH-PPV/PCBM). When using the structure in the context of solar energy applications it is important to provide a cost effective energy-absorbing layer. It is therefore advantageous to use crystalline silicon or amorphous silicon, which are available at mass production scales and easy to manipulate during the fabrication processes of solar cells.

However, given the rapid acceleration in the state of the art in regards to the processing of more complex materials, such as the aforementioned CIGSe and organic materials, the invention has been developed and tested to work with a range of materials that may become more economically viable in the future if processing technologies continue to improve.
A structure for infrared sensor applications might preferably consist of other materials, which are capable of absorbing radiation especially in a certain wavelength band. Hereby Indium Gallium Arsenide or for example Germanium or certain selenides, sulfides or arsenides such as lead selenide are of use in long wavelength photo detectors.

In a further preferred embodiment the reflector consists of a reflector base and a cavity wherein the cavity cladding abuts the cavity and wherein the cavity cladding is in direct contact or no further than 1 micron from the reflector base. In terms of simplification of the manufacturing of structures according to the invention the reflector is divided into two areas wherein the first area is the reflector base, which is preferably a flat sheet-like body and a cavity cladding, which is arranged at the upper side of the reflector and divides two cavities from each other. The cavity cladding can for example be cast, moulded, or patterned and etched on respectively at the reflector base in manufacturing with the use of processes such as lithography or any deposition method. In a particularly preferred embodiment the cavity cladding is made of the same material as the reflector base and contacts the reflector base as well as the absorbing layer.

In a beneficial embodiment the cavity has a symmetrical shape to enhance the absorption of radiation in all polarization states. Especially, when generating energy from solar light it is important to utilize radiation of all different polarization states to be able to absorb as much of the emitted solar radiation as possible with one and the same structure. A preferred symmetrical shape of the cavity allows for enhanced absorption of unpolarized radiation, as for example sunlight, irrespective of the orientation of the structure relative to the incoming radiation. Preferably the cavity has a shape, which is symmetrical to one or several planes or a direction orthogonal to the planar bottom surface of the reflector or the top surface of the reflector base. This symmetrical shape of the cavity allows for the utilization of the absorption enhancement functions of the cavity especially for sunlight light e.g. radiation with different polarization states. Preferably the cavity has a cylindrical or cubic shape, since these are the easiest to produce.

Alternatively preferred, the cavity has a rectangular shape to enhance the absorbing of radiation especially for one polarization state. When aiming to use the structure for example in sensor applications where the sensor might be used to measure radiation especially of one polarization state the cavity is preferably rectangular, slot-like, or one dimensional grating shaped. As a result of this geometry the absorption enhancement function of the cavity is optimized for a single polarization state or polarization angle. Furthermore, cavities of rectangular or circular shape are preferred as they are easy to produce. For instance the driving of slots into the material of the reflector can be achieved at a nanometer scale using existing fabrication technologies.

Especially preferred is the utilization of silver as a reflector material. Tests by the inventor have shown that silver material outperforms other metals, such as aluminum, in terms of absorption enhancement. On the other hand it might be preferred to use aluminum or molybdenum since they are much cheaper and comparatively easy to handle when manufacturing the structure according to the invention.

In a further preferred embodiment, for solar applications, the cavity core has a cavity width and the cavity cladding has a cladding width which when summed together give a period of between 10 nanometers and 1 micron for the structure. Further preferred the structure has a period between 100 nanometers and 400 nanometers.

Further preferred, defining the duty ratio as the ratio between cavity core and cladding in one period, with 0 being a core with no cladding and 1 being cladding material exclusively, is a duty ratio between 0.1 and 0.8.
Tests have shown especially when trying to absorb solar energy that depending on the further geometric characteristics of the structure an advantageous range of duty ratios is between about 0.2 to 0.7. Within this range it was possible to adapt for example the thickness of the reflector base and the thickness of the absorbing layer to gain optimum values for the absorbing enhancement. These ranges revealed an increase in absorption of light in a range of longer wavelengths, for example visible close to infrared light.

Further preferred the cavity has a specified cavity height and the reflector base has a specified base height wherein the cavity height and the base height parameters are tuned with the rest of the geometric parameters of the structure in order to support optical resonances in conjunction with the cavity's plasmonic effects.
For each specific implementation of the invention, the parameters must be evaluated based on computations performed with the exact thickness and specific optical properties of the absorbing material to be used. Amorphous Silicon's optical characteristics for example can vary greatly between production sites based on production methods and slight adulterations of the material with other chemicals, of which hydrogen is an example. Without setting the correct parameters for the specified radiation absorbing material and absorber height optimal enhancement will not be achieved. The preferred height of the cavity is between 5 nm and 5 microns, ideally between 10nm and 2 microns. The invention will perform in a suboptimal manner if an incorrect configuration of the reflector and substrate is used. For some material configurations, optimal effect will dictate the height of the reflector base. In those cases the preferred height of the base will be between 50 nm and 100 microns, ideally between 100nm and 50 microns, however alternate configurations, such as the use of an aluminum reflector in conjunction with a crystalline silicon absorber, may require the reflector to be used as an optical substrate to achieve maximum effect.

According to another invention a cell structure comprises an absorbing layer and a reflector wherein the reflector has an upper side wherein the upper side is heading or oriented towards the absorbing layer wherein at the upper side the reflector comprises a pattern of cavities wherein each cavity consists of dielectric material. The cell structure is in other words to be understood as a sequence of absorbing structures as described before. It preferably consists of one absorbing layer and one reflector. Between the absorbing layer and the reflector there is arranged a pattern of cavities. The cell structure may preferably furthermore contain additional layers for example a dielectric superstrate layer or an antireflection coating or a transparent conductive oxide, all preferably arranged on top of the absorbing layer. To support the cell a substrate might be arranged beneath the reflector as a carrier material.

In a first embodiment of the cell structure the cavities are separated by cavity claddings consisting of metal wherein the cavity claddings are preferably part of the reflector. Between the cavities several cavity claddings might be arranged wherein especially preferred the cavity claddings are part of the reflector material. In this course the reflector is for example etched with lithography at its upper side to form cavity claddings out of the upper surface of the reflector. Other preferred manufacturing methods are for example coating or lamination processes. In a next step the remaining cavities between the cavity claddings are preferably filled with dielectric material.

In a particularly preferred embodiment the cell structures includes one or several of the preferred features of the absorbing enhancement structure described before.

Additional advantages and features of the current invention are shown in the following description of preferred embodiments of the current invention with reference to the drawings attached. Single features or characteristics of respective embodiments are explicitly allowed to be combined with features of other embodiments within the scope of the current invention.
- Fig. 1: shows a first schematic view of a preferred embodiment of the current invention,
- Fig. 2: shows a perspective, explosion view of the elements in a preferred embodiment of the current invention,
- Fig. 3: shows a schematic view of a preferred embodiment of the cell structure according to the current invention,
- Fig. 4: shows a diagram with test results conducted by the applicant with a cell structure according to the current invention, and
- Fig. 5: shows four schematic perspective views of different embodiments of the absorbing structure.

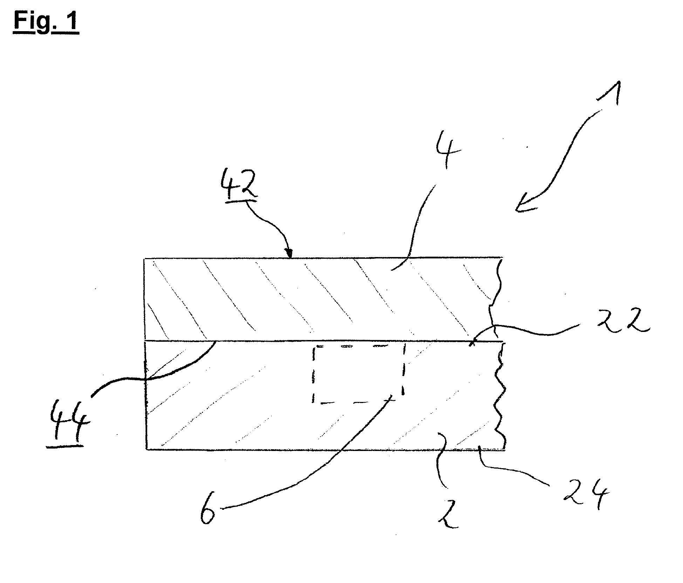

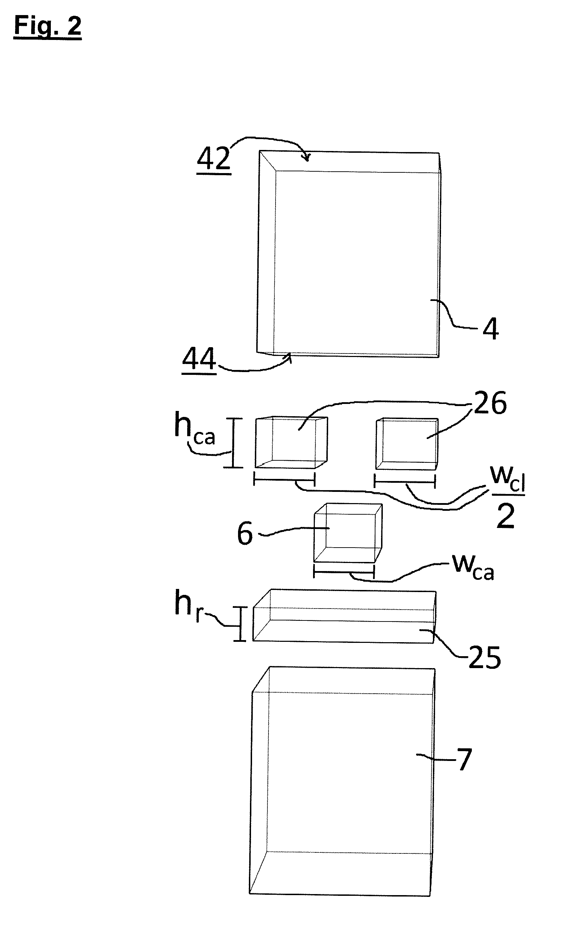

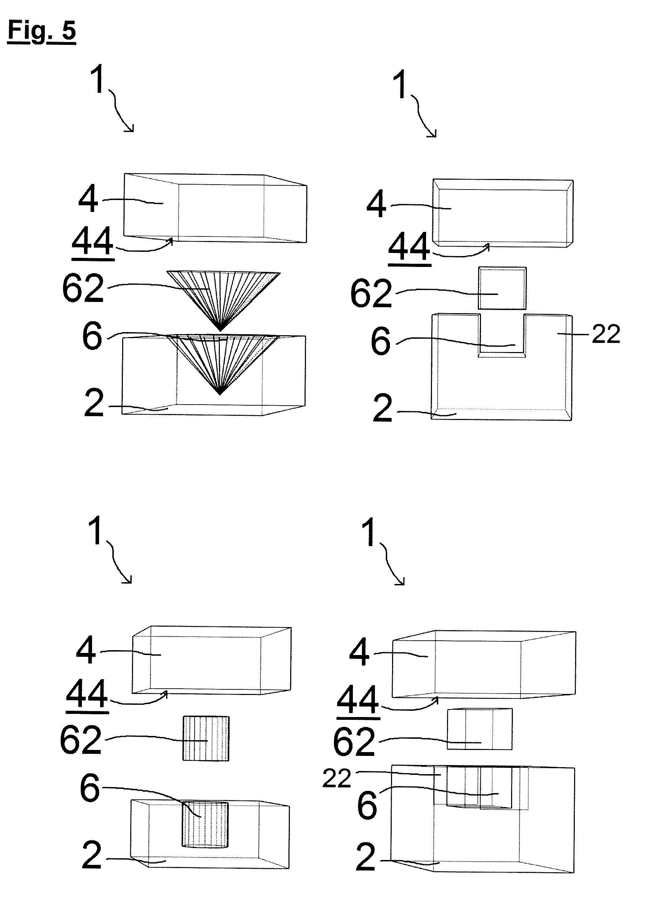

Fig. 1 clarifies the arrangement of the elements of an absorbing structure 1 according to a preferred embodiment of the current invention. The absorbing structure 1 comprises an absorbing layer 4 and a reflector 2 wherein the reflector has an upper side 22 and a lower side 24. At its upper side 22 the reflector 2 contacts a bottom surface 44 of the absorbing layer 4. The top surface 42 and the bottom surface 44 of the absorbing layer 4 are planar, which in other words means that there are no deliberately introduced irregularities in thickness. At the upper side 22 of the reflector 2 there is arranged a cavity 6 abutting the absorbing layer 4. The cavity 6 is filled with dielectric material, preferably glass. Certain shapes and geometry information of the cavity 6 is shown only very schematically in Fig. 1. These details can be found at the preferred embodiments shown in Fig. 2 and 5.

Fig. 2 shows an explosion view of the preferred elements of an absorbing structure 1. In this preferred embodiment the reflector 2 is divided into a reflector base 25 and two cavity claddings 26 while for means of better perception of the different elements the cavity claddings 26 are shown separated from the reflector base 25. In a final state of the absorbing structure 1 it is to be understood that the cavity claddings 26 are bound or fixed to the reflector base. In another preferred embodiment of the invention the cavity cladding 26 or the plurality of cavity claddings is forming one part together with the reflector base 25. Furthermore preferred, the cavity 6 has a basically cubic shape. The cavity claddings 26 have a cladding width w_{cl}, while the cladding width w_{cl} is the sum of the width of two cavity clad-dings 26 neighbouring one cavity 6. The cavity 6 has a cavity width w_{ca} measured preferably in the same direction as the cladding width w_{cl}. The ratio between the cavity width w_{ca} and the cladding width w_{cl}, which is a direct ratio not to be confused with the duty ratio, is preferably about 0.4 to 1.8. The ratio shown in Fig. 2 is the preferred range of 0.6 to 1.6, which allows especially for high absorption rates for light in an infrared band. Furthermore, the cavity height h_{ca} and the base height hᵣ are shown in Fig. 2. The preferred range of the ratio between the cavity height h_{ca} and the base height hᵣ is about 0.01 to 0.5. Shown in Fig. 2 is the in particular preferred value of this ratio about 0.08 to 0.1. Furthermore, it is shown that beneath the reflector base there is arranged a substrate layer 7, which supports the structure as claimed by the current invention. It is to be understood that on top of the absorbing layer 4 additional layers, like an anti-reflection coating, can be arranged to improve the performance of the absorbing structure 1. These additional layers preferably directly contact the top surface 42 of the absorbing layer 4.

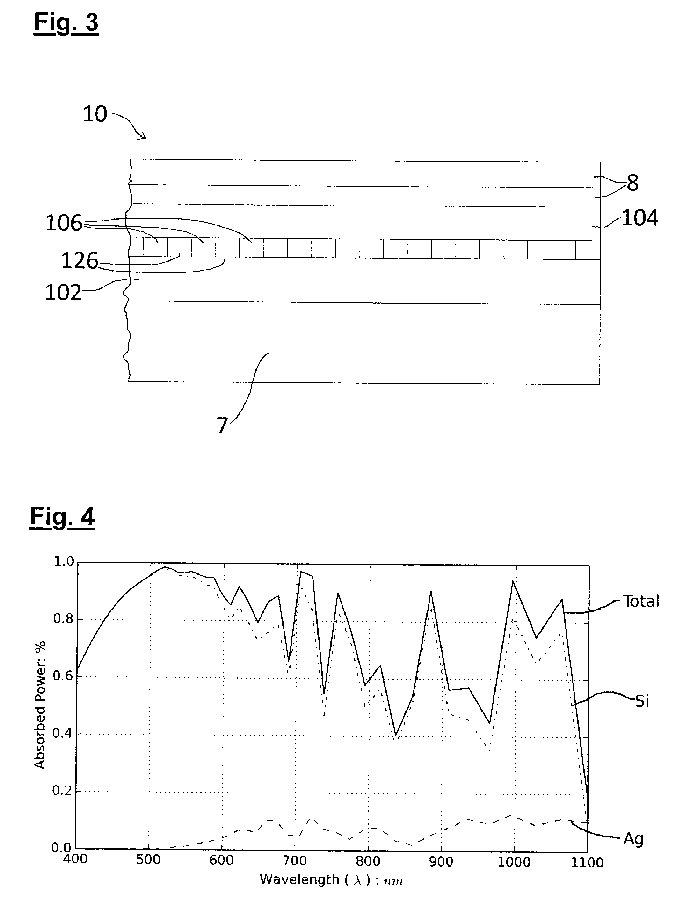

Fig. 3 shows a preferred embodiment of the cell structure 10 comprising an absorbing layer 104, a sequence of cavities 106 and a sequence of cavity claddings 126 arranged between these cavities 106. The cavity's claddings 126 are preferably part of the reflector 102. On top of the absorbing layer 104 there are arranged preferably two or several additional layers 8 to help to improve the absorption enhancement at the absorbing layer 104 and the reflector respectively the cavities 106 and 126. On its left side the cell structure 10 comprises electrical contacts to be connected to an electric wire receiving the electric current generated by the cell structure 10.

Fig. 4 shows a diagram illustrating the percentage of absorbed power in dependency of the wavelength of the incoming radiation. The different graphs are showing the absorbed power in the reflector 2 (labeled with AG), the absorbed power in the absorbing layer (SI) and the total amount of absorbed power (Total). This graph impressively shows that the reflector 2 made of silver has a very low amount of parasitic absorption while allowing very high values of percentage of absorbed power within a Silicon layer, which is current generating layer in a solar cell.

Fig. 5 clarifies different preferred shapes of the cavity 6, which preferably is filled with cavity filler 62. On the upper left side there is shown a conical shape of the cavity 6, which in particular is preferred to utilize radiation of different polarization states. In another preferred embodiment, the cavity 6 and the cavity filler 62 might be shaped rectangular which allows high absorption rates for radiation of a certain polarization state and is easy to produce. On the lower left side a cylindrical cavity is shown while on the lower right side a cubic cavity shape is shown. The cylindrical shape is preferably symmetrical to a direction orthogonal to the lower side 24 of the reflector 2. Accordingly the cubic shape is symmetrical to two orthogonal planes, which furthermore are orthogonal to the lower side 24 of the reflector 2. The cubic and the cylindrical shape allow the absorption of light with different polarization states. The cylindrically shaped cavity shown on the lower left side is especially preferred when producing the reflector 2 according to the invention with lithography.

### Reference numerals:

- 1: - structure
- 2, 102: - reflector
- 4, 104: - absorbing layer
- 6, 106: - cavity
- 7: - substrate layer
- 8: - additional layers
- 10: - cell structure
- 22: - upper side
- 24: - lower side
- 25: - reflector base
- 26, 126: - cavity cladding
- 42: - top surface
- 44: - bottom surface
- h_{ca}: - cavity height
- hᵣ: -base height
- w_{ca}: - cavity width
- w_{cl}: - cladding width

## Claims

1. Structure (1), in particular for use in thin layer cells, comprising a reflector (2) and an absorbing layer (4),
wherein the reflector (2) has an upper side (22) and a lower side (24), wherein the upper side (22) is oriented towards the absorbing layer (4), wherein at the upper side (22) the reflector (2) comprises a cavity (6) consisting of dielectric material.

2. Structure (1) according to claim 1,
wherein the absorbing layer (4) has a planar top surface (42) and a planar bottom surface (44),
wherein the bottom surface (44) is in close proximity to the upper side (22) of the reflector (2).

3. Structure (1) according to any of the preceding claims,
wherein the absorbing layer (4) directly contacts the material of the reflector (2) and/or the cavity (6).

4. Structure (1) according to any of the preceding claims,
wherein the absorbing layer (4) has a thickness of 5nm to 10 microns, preferably 50nm to 5 microns and in particular preferred of 200nm to 5 microns.

5. Structure (1) according to any of the preceding claims,
wherein the absorbing layer (4) consists of Gallium Arsenide (GaAs) and/or Crystalline Silicon (Si or C-Si) and/or Amorphous Silicon (a-Si) and/or Copper Indium Gallium Selenide Cu(In,Ga)Se2 (CIGSe) and/or Indium Gallium Selenide (InGaAs) and/or Organic absorbers (e.g. MEH-PPV/PCBM).

6. Structure (1) according to any of the preceding claims,
wherein the reflector (2) consists of a reflector base (25) and a cavity cladding (26), wherein the cavity cladding (26) abuts the cavity (6), and wherein the cavity cladding (26) is adhesively bond to the reflector base (25).

7. Structure (1) according to any of the preceding claims,
wherein the cavity (6) has a symmetrical shape to enhance the absorbing of radiation with different polarization states.

8. Structure (1) according to any of claims 1 to 6,
wherein the cavity (6) has a rectangular shape, to enhance the absorbing of radiation especially for one polarization state.

9. Structure (1) according to any of the preceding claims,
wherein the reflector (2) material is silver or aluminum or molybdenum.

10. Structure (1) according to any of the preceding claims,
wherein the cavity (6) has a cavity width (w_{ca}) and the cavity cladding (26) has a cladding width (w_{cl}),
wherein the ratio between the cavity width (w_{ca}) and the cladding width (w_{cl}) is about 0.4 to 1.8, preferably 0.6 to 1.6.

11. Structure (1) according to any of the preceding claims,
wherein the cavity (6) has a cavity height (h_{ca}) and the reflector base (25) has a base height (hᵣ),
wherein the cavity height (h_{ca}) is between 5nm and 5 microns, preferably between 10nm and 2 microns.

12. Cell structure (10) comprising an absorbing layer (104) and a reflector (102),
wherein the reflector (102) has an upper side (122),
wherein the upper side (122) is oriented towards the absorbing layer (104), wherein at the upper side (122) the reflector (102) comprises a pattern of cavities (106), wherein each cavity (106) consists of dielectric material.

13. Cell structure (10) according to claim 12,
wherein the cavities (106) are separated by cavity claddings (126) consisting of metal,
wherein the cavity claddings (126) are part of the reflector (102).

14. Cell structure (10) according to one of claims 12 or 13,
wherein the cell structure (10) includes the features of a Structure (1) according to any of claims 1 to 11.
